Europäisches Patentamt

European Patent Office

Office européen des brevets

(19)

(11) Veröffentlichungsnummer : **0 326 857 B1**

(12)

# EUROPÄISCHE PATENTSCHRIFT

(45) Veröffentlichungstag der Patentschrift :
18.12.91 Patentblatt 91/51

(51) Int. Cl.$^5$ : **H01L 31/075, H01L 27/142**

(21) Anmeldenummer : **89100808.8**

(22) Anmeldetag : **18.01.89**

---

(54) Dünnschichtsolarzellenanordnung.

---

(30) Priorität : **05.02.88 DE 3803519**

(43) Veröffentlichungstag der Anmeldung :
**09.08.89 Patentblatt 89/32**

(45) Bekanntmachung des Hinweises auf die
Patenterteilung :
**18.12.91 Patentblatt 91/51**

(84) Benannte Vertragsstaaten :
**DE FR GB IT**

(56) Entgegenhaltungen :
US-A- 4 316 049
US-A- 4 387 265
PATENT ABSTRACTS OF JAPAN, Band 7, Nr.
49 (E-161)[1194], 25. Februar 1983; & JP-A-57
199 272 (MITSUBISHI DENKI K.K.) 07-12-1982
PATENT ABSTRACTS OF JAPAN, Band 8, Nr.
221 (E-271)[1658], 9. Oktober 1984; & JP-A-59
105 379 (HITACHI SEISAKUSHO K.K.) 18-
06-1984

(56) Entgegenhaltungen :
PATENT ABSTRACTS OF JAPAN, Band 9, Nr.
280 (E-356)[2003], 8. November 1985; & JP-
A-60 123 074 (FUJI DENKI SOUGOU KENKY-
USHO K.K.) 01-07-1985
7TH E.C. PHOTOVOLTAIC SOLAR ENERGY
CONFERENCE, 27.-31. Oktober 1986, Sevilla,
Seiten 395-401, D. Reidel Publishing Co.; Y.
UCHIDA: "Light-induced degradation in amorphous silicon solar cells"
EXTENDED ABSTRACTS, Band 86-1, Nr. 1, Mai
1986, Seiten 457-458, Zusammenfassung Nr.
313, Princeton, New Jersey, US; A. LUQUE:
"The concept and the applications of bifacial
cells"

(73) Patentinhaber : SIEMENS
AKTIENGESELLSCHAFT
Wittelsbacherplatz 2
W-8000 München 2 (DE)

(72) Erfinder : Jürgens, Wilfried, Dipl.-Phys.
Kastelburgstrasse 87
W-8000 München 60 (DE)

Anmerkung : Innerhalb von neun Monaten nach der Bekanntmachung des Hinweises auf die Erteilung
des europäischen Patents kann jedermann beim Europäischen Patentamt gegen das erteilte europäische Patent Einspruch einlegen. Der Einspruch ist schriftlich einzureichen und zu begründen. Er gilt
erst als eingelegt, wenn die Einspruchsgebühr entrichtet worden ist (Art. 99(1) Europäisches Patentübereinkommen).

Jouve, 18, rue Saint-Denis, 75001 PARIS

**Beschreibung**

Die Erfindung betrifft eine Tandemsolarzellenanordnung im Dünnschichtaufbau.

Aus z.B.W. Heywang, "Amorphe und polykristalline Halbleiter", Springer Verlag, Berlin, Heidelberg, New York, Tokio 1984, Seite 58 bis 64 sind Dünnschichtsolarzellen bekannt, die einen sogenannten pin-Übergang enthalten. Dabei ist eine undotierte, d. h. intrinsische, i-Schicht auf der einen Seite mit einer p-dotierten p-Schicht und auf der gegenüberliegenden Seite mit einer n-dotierten n-Schicht versehen. Die i-Schicht ist z.B. auf der Basis von amorphem Silizium aufgebaut.

Eine effektive Solarzelle aus amorphem Silizium muß in der gesamten Absorptionszone ein gleichmäßiges und möglichst großes elektrisches Feld besitzen. Je höher die elektrische Feldstärke in der i-Schicht vorgesehen ist, desto weniger altert die Solarzelle. Eine höhere Feldstärke wird z.B. durch eine dünnere i-Schicht erzielt. Dadurch wird aber nur noch ein Teil des einfallenden Lichts absorbiert.

Es ist bekannt, mehrere serienverschaltete pin-Zellen übereinander zu stapeln (siehe z.B.W. Heywang, "Amorphe und polykristalline Halbleiter", Springer Verlag, Berlin, Heidelberg, New York, Tokio 1984, Seite 64). Dadurch vergrößert sich die Absorption des Lichts. Durch die Serienverschaltung vergrößert sich die Leerlaufspannung der Anordnung. Eine solche Anordnung, die aus zwei übereinander gestapelten Solarzellen besteht, wird allgemein Tandemzelle genannt und ist z.B. aus J. Yang, Intern. Conf. on Stability of a-Si Alloy Mat. and Devices, 28.-30. Jan. 87, Palo Alto. California, S. 295-303 bekannt.

Um das Spektrum des einfallenden Lichts besser auszunutzen, werden in einer Tandemzelle zwei Solarzellen kombiniert, die das Licht in unterschiedlichen Wellenlängenbereichen absorbieren (siehe z.B.J. Yang, Intern. Conf. on Stability of a-Si Alloy Mat. and Devices, 28.-30. Jan. 87, Palo Alto. California, S. 295-303). Die unterschiedliche Wellenlängenempfindlichkeit wird dabei durch unterschiedliche Zusätze zum amorphen Silizium der i-Schicht wie z.B. Kohlenstoff, Germanium oder Fluor erzielt.

Dabei ergibt sich die Schwierigkeit, die elektrischen Werte der beiden übereinanderliegenden, in Serie geschalteten Zellen anzupassen. In der Serienschaltung ist die Gesamtspannung der Tandemzelle der Anordnung die Summe der Einzelspannungen. Bei der Tandemzelle muß der Strom in beiden einzelnen Solarzellen gleich sein, wenn Verluste vermieden werden sollen. Die Anpassung der elektrischen Werte erfolgt z.B. durch Anpassung der Dicken der beiden i-Schichten.

Eine andere Möglichkeit (s.z.B.C. Eberspacher et al., 18th IEEE, Las Vegas 1985, S. 1031-1035) besteht darin, die beiden Solarzellen völlig isoliert, z.B. auf verschiedenen Seiten eines Substrates oder auf zwei Substraten, zu erzeugen. Jede Solarzelle ist dann mit zwei Kontakten versehen, die unabhängig verschaltet werden können. Das Aufbringen der Solarzellen auf den verschiedenen Seiten des Substrats ist umständlich und erfordert erhöhte Sorgfalt. Die Verschaltung der Solarzellen ist durch die vielen einzelnen Kontakte sehr arbeitsintensiv.

Aus der US-4387265 ist eine Dünnschichtsolarzellenanordnung mit mindestens zwei Solarzellen vom pin-Typ bekannt, die als Tandemsolarzellen übereinander angeordnet sind, wobei die benachbarten Schichten der ersten und zweiten Solarzelle vom selben Leitfähigkeitstyp sind und durch eine ohm'sche Kontaktschicht voneinander getrennt sind. Die Tandemsolarzelle ist mit drei elektrischen Anschlüssen versehen, wobei die Einzelsolarzellen in der Tandemsolarzelle z.B. parallel verschaltet sind.

Der Erfindung liegt die Aufgabe zugrunde, eine Tandemsolarzellenanordnung anzugeben, die stabil im Bezug auf Alterung ist, die einfach zu konziperen ist, die für Modulbauweise geeignet ist und die großtechnisch einfach herstellbar ist.

Die Aufgabe wird erfindungsgemäß gelöst von einer Tandemsolarzellenanordnung, deren einzelne Tandemsolarzellen (13, 14) die Schichtenfolge nipin oder pinip aufweisen und aus übereinander aufgebauten ersten und zweiten Solarzellen mit gemeinsamer Schicht und Kontaktschichten bzw. elektrischen Kontaktierungen bestehen, wobei die Anordnung folgende weitere Merkmale aufweist :

a) die Tandemzellen (13, 14) sind in einem Schichtaufbau (12) enthalten,

b) im Schichtaufbau (12) sind Gräben (15) vorgesehen, die die einzelnen Tandemzellen (13, 14) voneinander trennen,

c) die Gräben (15), die senkrecht zu den Schichten verlaufen, weisen jeweils an einer ersten Flanke (16) des Grabens (15) eine erste Stufe (17) auf, an deren Oberfläche die gemeinsame Schicht (5) liegt,

d) die erste Flanke (16) des Grabens (15) ist mit einer Isolatorschicht (20) bedeckt, die so strukturiert ist, daß sie die Oberfläche der ersten Stufe (17) unbedeckt läßt, aber alle anderen Schichten (2, 3, 4, 6, 7, 8) bedeckt,

e) die Gräben (15) weisen jeweils an einer zweiten Flanke (18), die der ersten Flanke (16) gegenüberliegt, eine zweite Stufe (19) auf, an deren Oberfläche die der Oberfläche des Schichtaufbaus (12) abgewandte Kontaktschicht (2) liegt,

f) die zweite Flanke (19) des Grabens (15) ist mit einer Isolatorschicht (20) bedeckt, die so strukturiert ist, daß die Kontaktschichten (2, 8) unbedeckt sind, aber alle anderen Schichten (3, 4, 5, 6, 7) bedeckt sind,

g) die Gräben (15) sind mit einem elektrisch leitfähigen Material (21) aufgefüllt.

Diese Anordnung hat den Vorteil einer erhöhten Stabilität in Bezug auf das Alterungsverhalten, da die Schichten dünn sein können (≤ 0.2 µm). Die elektrischen Spannungen an den beiden Einzel-Solarzellen sind gleich groß. Die Verschaltung der beiden Solarzellen in einer Tandemzelle entspricht einer Parallelschaltung. Die Ströme in den Zellen können daher beliebig sein, ohne den Wirkungsgrad der Anordnung zu verringern. Die Anpassung zweier Zellen in einer solchen Anordnung ist daher sehr einfach.

Um das Spektrum des einfallenden Lichts besser auszunutzen, wird für die intrinsischen i-Schichten der ersten Solarzelle und der zweiten Solarzelle intrinsisches Halbleitermaterial mit unterschiedlichen Zusätzen, die das Licht in unterschiedlichen Wellenlängenbereichen absorbieren, verwendet. Sind die i-Schichten z.B. auf der Basis von hydrogenisiertem amorphem Silizium vorgesehen, eignen sich beispielsweise Kohlenstoff, Germanium oder Fluor als Zusatz.

Die Stromableitung der gemeinsamen Schicht wird dadurch verbessert, daß auf der gemeinsamen Schicht ein Grid aus transparentem elektrisch leitfähigem Material, z.B. ITO (= Indium-Zinn-Oxid), vorgesehen ist.

Zur Kontaktierung der Solarzellenanordnung mit i-Schichten auf der Basis von amorphem Silizium müssen Kontaktschichten jeweils auf der, der gemeinsamen Schicht abgewandten Oberfläche der Schichtenfolge der Solarzellen vorgesehen werden. Mindestens eine dieser Kontaktschichten, durch die der Lichteinfall erfolgt, besteht dabei aus transparentem elektrisch leitfähigem Material. Die Kontaktierung über Kontaktschichten führt zu einer guten Stromableitung. Das Aufbringen von Kontaktschichten ist im Herstellprozeß technologisch einfacher als das Montieren einzelner Elektroden.

Bestehen beide Kontaktschichten aus transparentem, elektrisch leitfähigem Material, kann der Lichteinfall von beiden Seiten der Solarzellenanordnung genutzt werden.

Dadurch kann das Licht, das in der Dünnschichtsolarzellenanordnung nicht absorbiert wurde und das an der Fläche hinter der Dünnschichtsolarzellenanordnung zurück in die Dünnschichtsolarzellenanordnung reflektiert wird, weiter zur Stromerzeugung genutzt werden (sogenannte bifacialcells, s.z.B.A. Pantoja-Lopez, J. Garcia Martin, 7. EPSEC, Sevilla/Spanien 1986, S. 137-141)

Die Parallelverschaltung der beiden Solarzellen in jeder Tandemzelle erfolgt zusammen mit der Serienverschaltung im Modulaufbau und ist daher technologisch einfach. Der Schichtaufbau weist eine Schichtenfolge von einer ersten p-leitenden, einer ersten intrinsischen, einer gemeinsamen n-leitenden, einer zweiten intrinsischen und einer zweiten p-leitenden Schicht auf. Der ersten p-leitenden Schicht und der zweiten p-leitenden Schicht ist jeweils eine Kontaktschicht benachbart. Die einzelnen Tandemzellen werden im Schichtaufbau durch Gräben voneinander getrennt. Die Flanken der Gräben, die senkrecht zum Schichtaufbau verlaufen, sind so mit je einer strukturierten Isolatorschicht bedeckt, daß an der einen Flanke die gemeinsame n-leitende Schicht offenliegt und daß an der anderen, gegenüberliegenden Flanke die beiden Kontaktschichten offenliegen. Der Graben ist mit einem elektrisch leitfähigen Material aufgefüllt. Durch die Strukturierung der Isolatorschichten wird durch das leitfähige Material die gemeinsame n-leitende Schicht der einen Tandemzelle mit den Kontaktschichten und damit mit den p-leitenden Schichten der darauffolgenden Tandemzelle elektrisch verbunden.

Die Strukturierung der Isolatorschichten wird z.B. dadurch erreicht, daß in die Flanken des Grabens Stufen geätzt werden. An der Oberfläche der Stufen befinden sich die gemeinsame n-leitende Schicht bzw. die Kontaktschicht. Die Stufen werden beispielsweise durch selektives Ätzen erzeugt. Dazu ist es vorteilhaft, die n-leitenden oder p-leitenden Schichten aus mikrokristallinem Silizium vorzusehen.

Die erfindungswesentlichen Merkmale können selbstverständlich auch in einem Schichtaufbau mit einer Schichtfolge mit einer n-leitenden, einer intrinsischen, einer gemeinsamen p-leitenden, einer intrinsischen und einer n-leitenden Schicht realisiert sein.

Im folgenden wird die Erfindung anhand eines Ausführungsbeispiels und den FIG näher erläutert.

In FIG 1 ist eine Tandemzelle dargestellt.

FIG 2 zeigt schematisch den Potentialverlauf in einer Tandemzelle.

FIG 3 zeigt zwei in Serie Verschaltete Tandemsolarzellen gemäß der Erfindung.

Für gleiche Teile gelten in den Figuren gleiche Bezugszeichen.

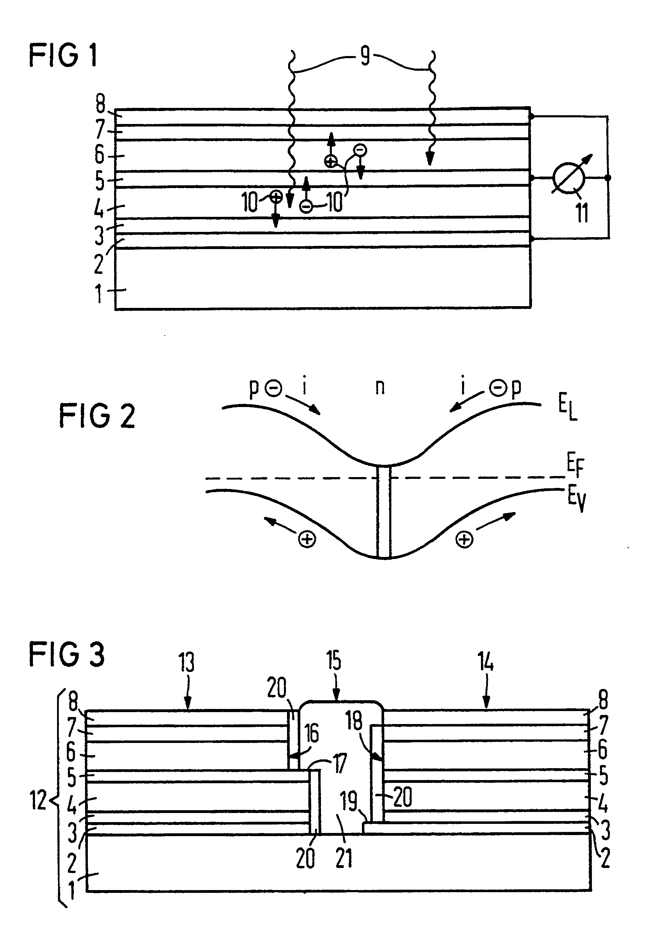

In FIG 1 ist eine Tandemzelle dargestellt. Auf einem Substrat 1 aus z.B. Glas ist eine erste Kontaktschicht 2, eine erste p-Schicht 3, eine erste i-Schicht 4, eine gemeinsame n-Schicht 5, eine zweite i-Schicht 6, eine zweite p-Schicht 7 und eine zweite Kontaktschicht 8 vorgesehen. Die erste Kontaktschicht 2 und die zweite Kontaktschicht 8 bestehen aus einem transparentem leitfähigem Material z.B. aus dotiertem $SnO_2$. Die erste p-Schicht 3 und die zweite p-Schicht 7 bestehen aus amorphem Silizium und sind durch Dotierung mit Bor p-leitend. Die erste i-Schicht 4 und die zweite i-Schicht 6 sind intrinsische Schichten. Die erste i-Schicht 4 besteht aus amorphem Silizium-Germanium. Die zweite i-Schicht 6 besteht aus amorphem Silizium. Die gemeinsame n-Schicht 5 besteht z.B. aus mikrokristallinem Silizium und ist durch Dotierung mit Phosphor n-leitend. Die Schichten haben folgende Dicken : erste p-Schicht 3: 15 bis 20 nm, erste i-Schicht 4 : 100 bis 250 nm, gemeinsame n-Schicht 5 : 20 bis 40 nm, zweite i-Schicht 6 : 300 bis 700 nm, zweite p-Schicht 7 : 15 bis 20 nm.

Im Betrieb der Tandemzelle in FIG 1 wird von der Seite der zweiten Kontaktschicht 8 her Licht, angedeutet als Pfeile 9, in die Tandemzelle eingestrahlt. Das Licht wird zum Teil in der ersten i-Schicht 4, zum Teil in der zweiten i-Schicht 6 absorbiert. Dabei werden Ladungsträger 10 erzeugt. Durch das elektrische Feld werden die Ladungsträger entsprechend ihrer Polarität zur gemeinsamen n-Schicht 5 bzw. zur ersten p-Schicht 3 oder zweiten p-Schicht 7 gezogen. Die gemeinsame n-Schicht 5 ist über einen Verbraucher 11 mit der ersten p-Schicht 3 und mit der zweiten p-Schicht 7 elektrisch verbunden.

In FIG 2 ist schematisch der Potentialverlauf in der Tandemzelle dargestellt entlang einem Schnitt, der senkrecht zur Schichtenfolge in FIG 1 verläuft. Die FIG 2 zeigt weiterhin wie der Ladungstransport durch Elektronen und Löcher erfolgt.

In FIG 3 sind zwei erfindungsgemäß in Serie geschaltete Tandemzellen dargestellt, die in einem Schichtaufbau 12 enthalten sind. Der Schichtaufbau 12 enthält das Substrat 1, die erste Kontaktschicht 2, die erste p-Schicht 3, die erste i-Schicht 4, die gemeinsame n-Schicht 5, die zweite i-Schicht 6, die zweite p-Schicht 7 und die zweite Kontaktschicht 8. In dem Schichtaufbau 12 sind eine erste Tandemzelle 13 und eine zweite Tandemzelle 14 durch einen Graben 15 getrennt. Der Graben 15 verläuft senkrecht zur Schichtenfolge bis auf das Substrat 1. Eine erste Flanke 16 des Grabens 15 weist eine erste Stufe 17 auf. Die erste Flanke 16 begrenzt die erste Tandemzelle 13. Die erste Stufe 17 verläuft entlang der Oberfläche der gemeinsamen n-Schicht 5.

Eine zweite Flanke 18 des Grabens 15, die der ersten Flanke 16 gegenüberliegt und die die zweite Tandemzelle 14 begrenzt, weist eine zweite Stufe 19 auf. Die zweite Stufe 19 verläuft an der Oberfläche der ersten Kontaktschicht 2. Die erste Flanke 16 und die zweite Flanke 18 sind mit je einer strukturierten Isolatorschicht 20 bedeckt. Die Isolatorschichten 20 sind so strukturiert, daß an der ersten Flanke 16 alle Schichten bedeckt sind bis auf die gemeinsame n-Schicht 5 und daß an der zweiten Flanke 18 alle Schichten bedeckt sind bis auf die erste Kontaktschicht 2 und die zweite Kontaktschicht 8. Der Graben 15 ist mit elektrisch leitfähigem Material 21 aufgefüllt. Durch die Strukturierung der Isolatorschichten 20 verbindet das elektrisch leitfähige Material 21 die gemeinsame n-Schicht 5 an der ersten Flanke 16 mit der ersten Kontaktschicht 2 und der zweiten Kontaktschicht 8 an der zweiten Flanke 18. Dadurch ist die gemeinsame n-Schicht 5 der ersten Tandemzelle 13 elektrisch mit der ersten p-Schicht 3 und der zweiten p-Schicht 7 der zweiten Tandemzelle 14 verbunden.

Durch eine vielfache Wiederholung der anhand FIG 3 erläuterten Verbindung zwischen zwei Tandemzellen ist in einem Modul mit vielen Tandemzellen gewährleistet, daß die Tandemzellen seriell verschaltet sind und gleichzeitig die in den Tandemzellen enthaltenen Solarzellen parallel verschaltet sind.

## Patentansprüche

1. Tandemsolarzellenanordnung im Dünnschichtaufbau, deren einzelnen Tandemsolarzellen (13, 14) die Schichtenfolge nipin oder pinip aufweisen und aus übereinander aufgebauten ersten und zweiten Solarzellen mit gemeinsamer Schicht und Kontaktschichten bzw. elektrischen Kontaktierungen bestehen, wobei die Anordnung folgende weitere Merkmale aufweist:

a) die Tandemzellen (13, 14) sind in einem Schichtaufbau (12) enthalten,

b) im Schichtaufbau (12) sind Gräben (15) vorgesehen, die die einzelnen Tandemzellen (13, 14) voneinander trennen,

c) die Gräben (15), die senkrecht zu den Schichten verlaufen, weisen jeweils an einer ersten Flanke (16) des Grabens (15) eine erste Stufe (17) auf, an deren Oberfläche die gemeinsame Schicht (5) liegt,

d) die erste Flanke (16) des Grabens (15) ist mit einer Isolatorschicht (20) bedeckt, die so strukturiert ist, daß sie die Oberfläche der ersten Stufe (17) unbedeckt läßt, aber alle anderen Schichten (2, 3, 4, 6, 7, 8) bedeckt,

e) die Gräben (15) weisen jeweils an einer zweiten Flanke (18), die der ersten Flanke (16) gegenüberliegt, eine zweite Stufe (19) auf, an deren Oberfläche die der Oberfläche des Schichtaufbaus (12) abgewandte Kontaktschicht (2) liegt,

f) die zweite Flanke (19) des Grabens (15) ist mit einer Isolatorschicht (20) bedeckt, die so strukturiert ist, daß die Kontaktschichten (2, 8) unbedeckt sind, aber alle anderen Schichten (3, 4, 5, 6, 7) bedeckt sind,

g) die Gräben (15) sind mit einem elektrisch leitfähigen Material (21) aufgefüllt.

2. Anordnung nach Anspruch 1, dadurch **gekennzeichnet**, daß die i-Schicht (4) der ersten Solarzelle und die i-Schicht (6) der zweiten Solarzelle aus unterschiedlichen intrinsischen Halbleitermaterialien, die das Licht in unterschiedlichen Wellenlängenbereichen absorbieren, bestehen.

3. Anordnung nach Anspruch 1 oder Anspruch 2, dadurch **gekennzeichnet**, daß die i-Schichten (4, 6) der ersten Solarzelle und der zweiten Solarzelle auf der Basis von amorphem Silizium vorgesehen sind, daß zur Kontaktierung der ersten Solarzelle und der zweiten Solarzelle jeweils auf der der gemeinsamen Schicht abgewandten Oberfläche der Schichtenfolge eine Kontaktschicht (2, 8) aus elektrisch leitfähigem Material vorgesehen ist und mindestens die dem Licht zugewandte Kontaktschicht (8) aus transparentem Material besteht.

4. Anordnung nach einem der Ansprüche 1 bis 3, dadurch **gekennzeichnet**, daß mindestens eine der n-Schichten (5) und der p-Schichten (3, 7) aus mikrokristallinem Silizium vorgesehen ist.

5. Anordnung nach einem der Ansprüche 1 bis 4, dadurch **gekennzeichnet**, daß zur Unterstützung der Stromableitung auf der gemeinsamen Schicht (5) ein Grid aus transparentem leitfähigen Material vorgesehen ist.

6. Anordnung nach einem der Ansprüche 1 bis 5, dadurch **gekennzeichnet**, daß beide Kontaktschichten (2, 8) aus transparentem elektrisch leitfähigem Material bestehen.

7. Verwendung einer Anordnung nach Anspruch 6 in einem Modul, in dem der Lichteinfall von beiden Seiten genutzt wird.

8. Verwendung einer Dünnschichtsolarzellenanordnung nach Anspruch 6 in einem Modul, das vor einem reflektierenden Hintergrund aufgebaut ist, wobei nicht absorbiertes Licht am Hintergrund reflektiert wird und nochmals die Dünnschichtsolarzellenanordnung durchstrahlt.

## Claims

1. Tandem solar cell arrangement of thin film construction, the individual tandem solar cells (13, 14) of which have the layer sequence nipin or pinip and consist of first and second solar cells having a common layer and contact layers or electrical contacts, constructed one above the other, the arrangement having the following further features :

    a) the tandem cells (13, 14) are contained in a layer construction (12),

    b) grooves (15) are provided in the layer construction (12) which separate the individual tandem cells (13, 14) from one another,

    c) the grooves (15), which run perpendicular to the layers, have a first step (17) in each case on a first aide wall (16) of the groove (15), the common layer (5) being positioned on the surface of the first step (17),

    d) the first side wall (16) of the groove (15) is covered with an insulating layer (20) which is structured such that it leaves the surface of the first step (17) uncovered, but covers all the other layers (2, 3, 4, 5, 6, 7, 8),

    e) the grooves (15) have a second step (19), in each case on a second side wall (18) which is positioned opposite the first side wall, the contact layer (2) being positioned on the second step surface (19) in facing away from the surface of the layer construction (12),

    f) the second side wall of the groove (15) is covered with an insulating layer (20) which is structured such that the contact layers (2, 8) are uncovered, but all the other layers (3, 4, 5, 6, 7) are covered,

    g) the grooves (15) are filled with an electrically conductive material (21).

2. Arrangement according to Claim 1, characterised in that the i-layer (4) of the first solar cell and the i-layer (6) of the second solar cell consist of different intrinsic semiconductor materials which absorb the light in different wavelength bands.

3. Arrangement according to Claim 1 or Claim 2, characterised in that the i-layers (4, 6) of the first solar cell and of the second solar cell are provided on the base of amorphous silicon, in that a contact layer (2, 8) of electrically conductive material, for making contact with the first solar cell and with the second solar cell, is provided in each case on the surface of the layer sequence facing away from the common layer, and at least the contact layer (8) facing the light consists of transparent material.

4. Arrangement according to one of Claims 1 to 3, characterised in that at least one of the n-layers (5) and of the p-layers (3, 7) is provided from microcrystalline silicon.

5. Arrangement according to one of Claims 1 to 4, characterised in that a grid of transparent conductive material is provided to support the discharge of current from the common layer (5).

6. Arrangement according to one of Claims 1 to 5, characterised in that the two contact layers (2, 8) consist of transparent, electrically conductive material.

7. Use of an arrangement according to Claim 6 in a module in which the incident light is used by both sides.

8. Use of a thin film solar cell arrangement according to Claim 6 in a module which is constructed in front of a reflecting background, light that is not absorbed being reflected from the background and passing through the thin film solar cell arrangement again.

## Revendications

1. Dispositif à piles solaires en tandem réalisé selon une structure à couches minces et dont les différentes piles solaires en tandem (13, 14) possèdent la succession de couches nipin ou pinip et sont constituées par des première et seconde piles solaires superposées possédant une couche commune et des couches de contact ou des contacts électriques, le dispositif possédant les autres caractéristiques suivantes :

    a) les piles en tandem (13, 14) sont situées dans un empilage de couches (12),

    b) dans l'empilage de couches (12) sont ménagés des sillons (15) qui séparent les unes des autres les différentes piles en tandem (13, 14),

    c) les sillons (15), qui sont perpendiculaires aux couches, possèdent, respectivement au niveau d'un premier flanc (16), une première partie étagée (17), sur la surface de laquelle est en appui la couche commune (5),

d) le premier flanc (16) du sillon (15) est recouvert par une couche isolante (20) structurée de telle sorte qu'elle laisse à découvert la surface de la première partie étagée (17), mais recouvre toutes les autres couches (2, 3, 4, 6, 7, 8),

e) les sillons (15) possèdent, respectivement au niveau d'un second flanc (18) qui est situé en vis-à-vis du premier flanc (16), une seconde partie étagée (19), sur la surface de laquelle est située la couche de contact (2) tournée à l'opposé de la surface de l'empilage de couches (12),

f) le second flanc (19) du sillon (15) est recouvert d'une couche isolante (20) structurée de telle sorte que les couches de contact (2, 8) ne sont pas masquées, mais que toutes les autres couches (3, 4, 5, 6, 7) sont masquées,

g) les sillons (15) sont remplis par un matériau électriquement conducteur (21).

2. Dispositif suivant la revendication 1, caractérisé par le fait que la couche i (4) de la première pile solaire et la couche i (6) de la seconde pile solaire sont constituées par des matériaux semiconducteurs intrinsèques différents, qui absorbent la lumière dans des gammes différentes de longueurs d'onde.

3. Dispositif suivant la revendication 1 ou 2, caractérisé par le fait que les couches i (4, 6) de la première pile solaire et de la seconde pile solaire sont prévues sur la base de silicium amorphe, que pour l'établissement du contact avec la première pile solaire et la seconde pile solaire, il est prévu, respectivement sur la surface de la pile de la succession de couches, tournée à l'opposé de la couche commune, une couche de contact (2, 8) réalisée en un matériau électriquement conducteur, et au moins la couche de contact (8) tournée vers la lumière est réalisée en un matériau transparent.

4. Dispositif suivant l'une des revendications 1 à 3, caractérisé par le fait qu'il est prévu au moins l'une des couche n (5) et l'une des couches p (3, 7) réalisées en silicium microcristallin.

5. Dispositif suivant l'une des revendications 1 à 4, caractérisé par le fait que pour assister la dérivation du courant sur la couche, une grille formée d'un matériau conducteur et transparent est prévue sur la couche commune (5).

6. Dispositif suivant l'une des revendications 1 à 5, caractérisé par le fait que les deux couches de contact (2, 8) sont réalisées en un matériau électriquement conducteur et transparent.

7. Mise en oeuvre d'un dispositif suivant la revendication 6 dans un module, dans lequel on utilise l'incidence de la lumière sur les deux faces.

8. Mise en oeuvre d'un dispositif à pile solaire à couches minces suivant la revendication 6 dans un module, qui est monté devant un fond réfléchissant, la lumière non absorbée étant réfléchie sur le fond et traversant à nouveau le dispositif à piles solaires à couches minces.

FIG 1

FIG 2

$$p \ominus \quad i \qquad n \qquad i \quad \ominus p \qquad E_L$$

$$E_F$$

$$E_V$$

FIG 3